# EUROPÄISCHE PATENTSCHRIFT

(11) **EP 1 358 190 B1**
(45) Veröffentlichungstag und Bekanntmachung des Hinweises auf die Patenterteilung: **26.04.2006**
(21) Anmeldenummer: 02712755.4
(22) Anmeldetag: 07.02.2002
(51) Int. Cl.: C07F 5/02, C09K 11/63

(54) **AMORPHE ORGANISCHE 1,3,2-DIOXABORINLUMINOPHORE, VERFAHREN ZU DEREN HERSTELLUNG UND VERWENDUNG DAVON**
AMORPHOUS ORGANIC 1,3,2-DIOXABORINE LUMINOPHORES, METHOD FOR THE PRODUCTION AND USE THEREOF
SUBSTANCES LUMINESCENTES DE 1,3,2-DIOXABORINE ORGANIQUES AMORPHES, LEUR PROCEDE D'OBTENTION ET LEUR APPLICATION

(30) Priorität: 09.02.2001 DE 10105916
(43) Veröffentlichungstag der Anmeldung: 05.11.2003
(73) Patentinhaber: Osram Opto Semiconductors GmbH, 93049 Regensburg (DE)
(72) Erfinder: HUNZE, Arvid, 91056 Erlangen (DE); KANITZ, Andreas, 91333 Höchstadt (DE); HARTMANN, Horst, 06217 Merseburg (DE); ROHDE, Dirk, 04275 Leipzig (DE); ROGLER, Wolfgang, 91096 Möhrendorf (DE)
(74) Vertreter: Epping - Hermann - Fischer
(86) Internationale Anmeldenummer: PCT/DE2002/000457
(87) Internationale Veröffentlichungsnummer: WO 2002/064600

(56) Entgegenhaltungen:
- DATABASE WPI Section Ch, Week 199415 Derwent Publications Ltd., London, GB; Class E13, AN 1994-125119 XP002200050 & SU 1 148 291 A (SHERSHUKOV V M), 30. Dezember 1993 (1993-12-30)

## Beschreibung

Die Erfindung betrifft Luminophore mit halbleitenden Eigenschaften sowie deren Herstellung und ihre Anwendung in organischen Leuchtdioden (OLEDS) und organischen Solarzellen.

Die neuen Halbleitermaterialien sind zur Abdeckung des langwellig emittierenden Spektralbereiches (orange bis rot) geeignet und gehören zu den "small molecules", obwohl sie sich auch durch spin coating verarbeiten lassen. Die Materialien eignen sich sowohl zum Aufbau organischer lichtemittierender Dioden (OLEDs) als auch zum Aufbau organischer photovoltaischer Elemente und schließlich auch zum Aufbau weiterer organischer elektronischer Bauelemente, wobei diese Materialien sowohl in Loch- als auch in Elektronentransportschichten und in Emitterschichten Verwendung finden können.

Die Materialien sind präperativ in hohen Ausbeuten zugänglich und leiten sich von 2-N,N-Di(het)arylamino-thiophen- und/oder -thiazol-derivaten ab.

Es besteht weiterhin der Bedarf an neuen organischen halbleitenden und/oder emittierenden Materialien für die verschiedensten Verwendungen in organischen Bauelementen und Leuchtdioden.

Aufgabe der Erfindung ist es, neue organische, amorphe, langwellig e-lektrolumineszierende Verbindungen zu schaffen, die in organischen Leuchtdioden und /oder organischen elektronischen Bauelementen verwendet werden können, die präparativ gut zugänglich und in Massenfertigungsprozessen leicht verarbeitbar sind.

Gegenstand der Erfindung sind 1,3,2-Dioxaborinluminophore der Typen **XI, XII** und **XIII** (Reaktionsschema C) **XIV** und/oder **XV** (Reaktionsschema D)
wobei Folgendes gilt:
R¹, R² ,R³ ,R⁴ und R⁹ sind - unabhängig voneinander - jeweils ein monofunktionelles (Het)arylsystem, d.h. ein konjugiertes carbocyclisches oder heterocyclisches Ringsystem, das auch aus linear oder angular anellierten oder verknüpften gleichen oder unterschiedlichen Ringtypen bestehen kann, wobei die peripheren Wasserstoffatome gegebenenfalls durch Alkyl-, Alkoxy-, Phenoxy-, Dialkylamino- oder Diphenylaminogruppen (Alkyl = C₁ bis C₆) substituiert sein können;
darüberhinaus können R¹ und R² im Verbindungstyp **XV** auch verzweigte oder unverzweigte Alkylgruppierungen (C₁-C₆) sein oder mit dem gebundenen N-Atom gemeinsam einen Pyrrolidin-, Piperidin- oder Morpholinring bilden;
R³ und R⁴ können ferner auch unabhängig voneinander H sein;
R⁸ kann eine chemische Bindung oder ein entsprechendes bifunktionelles (Het)arylensystem sein, d.h. ein konjugiertes carbocyclisches oder heterocyclisches Ringsystem, das auch aus linear oder angular anellierten oder verknüpften gleichen oder unterschiedlichen Ringtypen bestehen kann, wobei die peripheren Wasserstoffatome gegebenenfalls durch Alkyl-, Alkoxy-, Phenoxy-, Dialkylamino- oder Diphenylaminogruppen (Alkyl = C₁ bis C₆) substituiert sein können.

Weiterhin ist Gegenstand der Erfindung ein Verfahren zur Herstellung der Verbindungen der Typen **XI, XII, XIII, XIV** und **XV.**

Schließlich ist Gegenstand der Erfindung die Verwendung der Verbindungen der Typen **XI, XII, XIII, XIV** und **XV** in organischen Leuchtdioden, organischen Solarzellen, photorefraktiven Bauelementen und/oder sonstigen elektronischen Bauelementen mit organischen Funktionsschichten.

Die erfindungsgemäßen neuen Verbindungen sind präparativ leicht zugänglich und leiten sich sämtlich aus einem Baukastensystem (siehe Reaktionsschemata A-D)von N,N-disubstituierten Carbonsäureamiden **II** bzw. N,N-disubstituierten Thiocarbonsäureamiden **IV** ab. Sie sind im Rahmen von Massenfertigungsverfahren gut verarbeitbar.

Für die Bildung der Ausgangssynthons und Dioxaborinvorstufen gilt Folgendes:
R⁵ und R⁶ sind unabhängig voneinander H, C₁- bis C₁₀-Alkyl oder Phenyl oder bilden gemeinsam eine C₄- bis C₆₋Alkylengruppierung oder eine Gruppierung -CH₂-CH₂-O-CH₂-CH₂-;
R⁷ ist ein verzweigter oder unverzweigter Alkylrest;
X ist ein Halogen, bevorzugt Cl, Br oder I;
A⁻ ist das Anion des Vilsmeier-Reagenz, bevorzugt auch ClO₄⁻.
R¹⁰ hat die Bedeutung von R¹, bevorzugt aber, die Bedeutung vom Strukturtyp **VIII**, wobei R¹ und R² im Verbindungstyp **VIII** auch verzweigte oder unverzweigte Alkylgruppierungen (C₁-C₆) bedeuten können oder mit dem gebundenen N-Atom gemeinsam einen Pyrrolidin-, Piperidin- oder Morpholinring bilden.

### Reaktionsschemata:

### A: Bildung der Ausgangssynthons

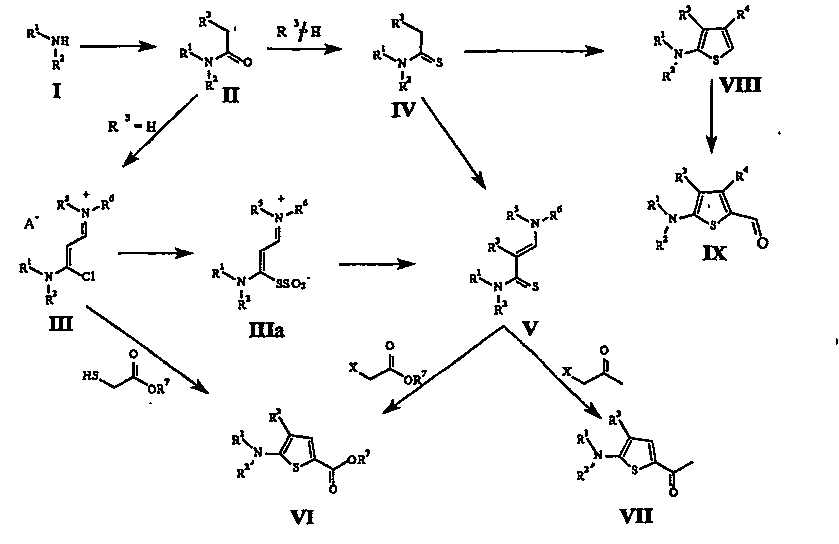

Ausgehend von den Carbonsäureamiden **II** sind die Ausgangssynthons die vinylogen Thiocarbonsäureamide **V,** die 2-N,N-disubsti-tuierten Aminothiophen-5-yl-carbonsäureester **VI,** die 2-N,N-disubstituierten Aminothien-5-yl-acetophenone **VII** und die 2-N,N-disubstituierten Amino-5-formyl-thiophene **IX** (Reaktionsschema A) für die Darstellung der elektrolumineszierenden Luminophore einfach und in hohen Ausbeuten zugänglich.

Die Gewinnung der vinylogen Thiocarbonsäureamide **V** erfolgt dabei durch zwei unterschiedliche Syntheserouten. Für die Darstellung der 3-substituierten vinylogen Thiocarbonsäureamide **V** werden die entsprechenden Carbonsäureamide **II** mittels Lawessons-Reagenz in die zugehörigen Thiocarbonsäureamide **IV** umgewandelt, um im nächsten Reaktionsschritt das Synthon **V** durch eine Aminoformylierung nach Liebscher mittels Orthoameisensäureester und einem über 100°C siedenden sec. Amin zu erhalten. Die 3-unsubstituierten vinylogen Thiocarbonsäureamide **V** werden dagegen aus den Carbonsäureamiden **II** durch Arnold Reaktion die Chlorpropeniminiumsalze **III** erzeugt, aus welchen die Synthons **V** über die Stufe der Bunte-Salze durch Reaktion mittels eines Thiosulfates und anschließender Sulfitextrusion erhalten werden.

Aus den Thiocarbonsäureamiden **IV** die durch eine Hantzsch-analoge Reaktion in entsprechende 2-N,N-disubstituierte Aminothiophene **VIII** überführt werden, können aus diesen durch Vilsmeier Reaktion 2-N,N-disubstituierte Amino-5-formyl-thiophene **IX** erhalten werden.

Aus den vinylogen Thiocarbonsäureamiden **V** werden in Hantzschanalogen Reaktionen durch Umsetzung mit 2-Halogenessigsäureestern die Synthons **VI** sowie durch Umsetzung mit 2-Halogenaceton die Synthons **VII** erhalten. Die 3-unsubstituierten Synthons VI können auch direkt aus den Arnold Produkten **III** durch Thioessigsäureester infolge S-Alkylierung und Cyclisierung sowie deren Stabilisierung durch Kondensation zum Aromaten gebildet werden.

### B: Darstellung der 1,3,2-Dioxaborinvorstufen

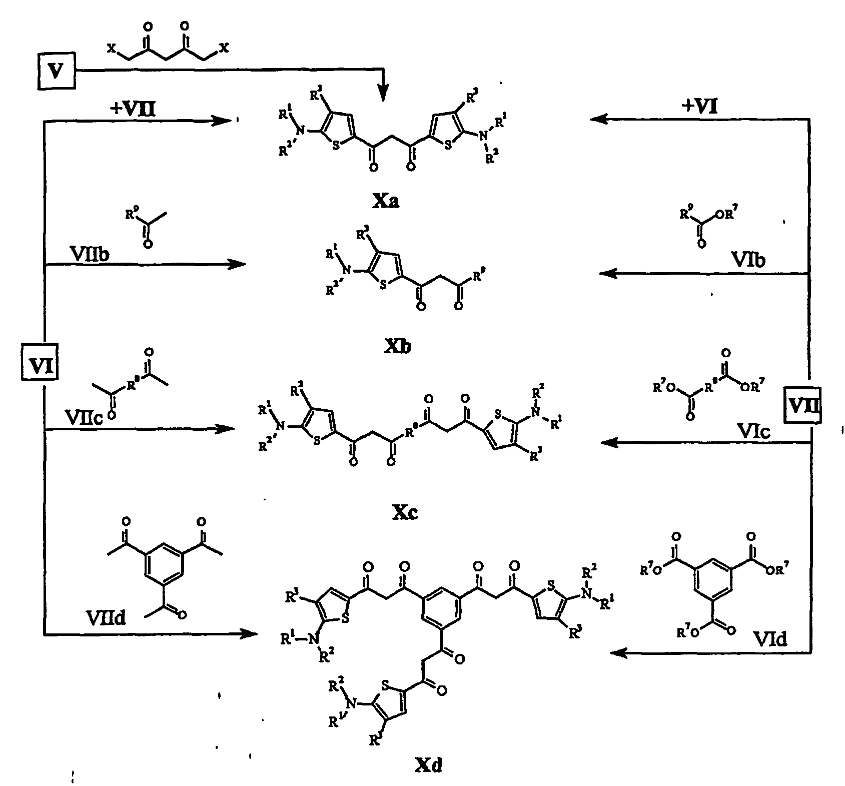

Die Darstellung der 1,3,2-Dioxaborinvorstufen, die 1,3-Diketone **X** (Reaktionsschema B) erfolgt aus den Synthons **V**, **VI** und **VII.**

Aus dem Synthon des Typs **V** erhält man die substituierten 1,3-Dithienylpropan-1,3-dione **Xa** durch eine bifunktionelle Hantzsch-analoge Reaktion bei der Umsetzung mit 1,5-Dihalogenpentan-2,4-dionen.

Eine weitere einfache Möglichkeit die Dioxaborinvorstufen **Xa** zu synthetisieren erfolgt in einer Claisenkondensation aus den Thienylcarbonsäureestern des Typs **VI** mit den Thienylacetophenonen des Typs **VII** in Gegenwart einer starken Base in einem unpolaren Lösungsmittel.

In gleicher Weise erzeugt man entsprechende unsymmetrische 1,3,2-Dioxaborinvorstufen des Typs **Xb** durch Umsetzung der Thienylcarbonsäureester des Typs **VI** mit beliebigen Acetophenonen **VIIb** oder umgekehrt durch Umsetzung der Thienylacetophenone **VII** mit beliebigen (Het)arylcarbonsäureestern **VIb.** Um Bis- und Tris-1,3,2-dioxaborinvorstufen **Xc** bzw. **Xd** zu erhalten werden entsprechende Diacetylderivate **VIIc** bzw. Triacetylderivate **VIId** mit den Thienylcarbonestern des Typs **VI** umgesetzt oder die entsprechenden Di- bzw. Tricarbonester **VIc** bzw. **VId** mit den Thienylacetophenonen des Typs **VII.**

### C: Bildung der Dioxaborine:

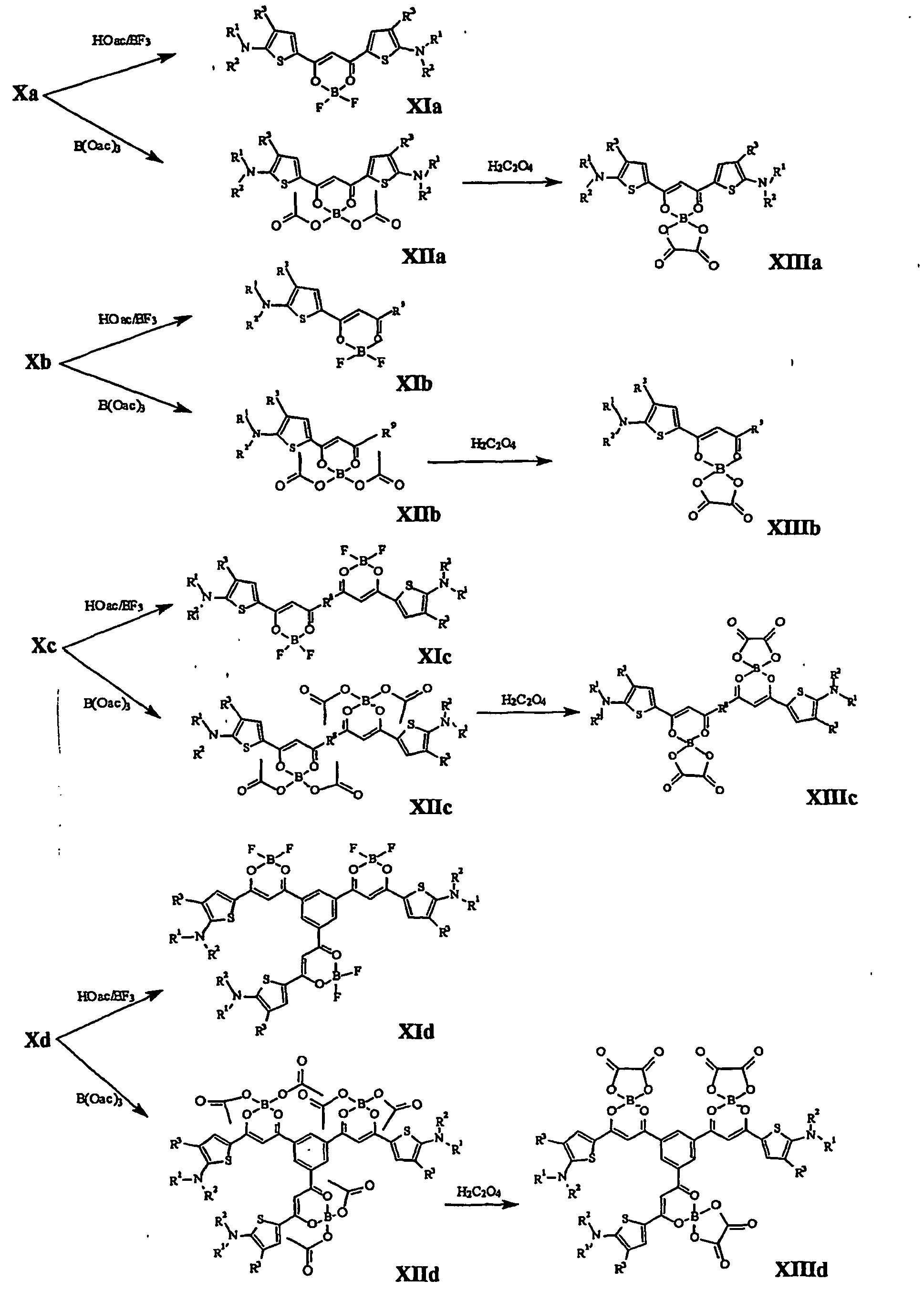

Die besonders einfache Umwandlung der 1,3-Diketoderivate **X** in die 1,3,2-Dioxaborinluminophore **XI** und **XII** sowie der Ligandenaustausch zur Bildung der 1,3,2-Dioxaborinluminophore **XIII** ist im Reaktionsschema C dargestellt. Dazu werden die 1,3-Diketoderivate in Acetanhydrid mit einem Borsäurederivat (Essigsäure-Bortrifuorid-Komplex bzw.. Bortriacetat) für kurze Zeit bis zum Rückfluß erhitzt, wobei die erfindungsgemäßen Luminophore **XI** und **XII** bei der Abkühlung ausfallen.

Die Borliganden in den Komplexen **XII** können auch beliebige Alkyl- oder Aryloxyliganden sein, wobei die Alkylgruppierungen verzweigt bzw. unverzweigt 1 bis 18 C-Atome enthalten können. Die Bildung der entsprechenden Borester wird durch thermische Entwässerung der entsprechenden Carbonsäuren in Gegenwart von Borsäure in situ durchgeführt.

Weiterhin läßt sich in Dichlorethan mit den 2,2-Diacetyl-1,3,2-dioxaborinen **XII** ein Ligandenaustausch bewerkstelligen, daß in Gegenwart von Oxalsäure in der Siedehitze die noch langwelliger emittierenden und stabileren 2,2-Oxalato-1,3,2-dioxaborine **XIII** erhalten werden.

Für diesen Ligandenaustausch können natürlich auch andere Dicarbonsäuren eingesetzt werden, vorzugsweise neben Oxalsäure Malonsäure, Alkylmalonsäure oder Dialkylmalonsäure.

### D: Bildung (het)-arylstyryl-substituierter Dioxaborine:

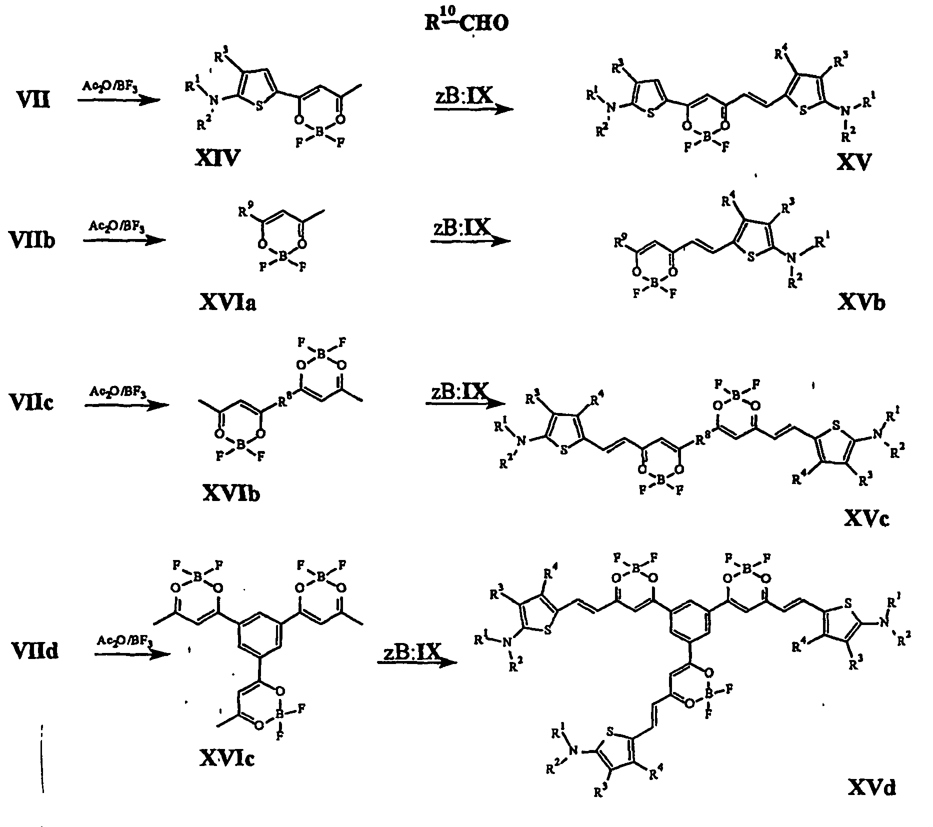

Im Reaktionsschema D wird eine weitere Methode zur Darstellung von 2,2-Difluoro-1,3,2-dioxaborinen genutzt, um vinyloge 1,3,2-Dioxaborinluminophore **XV** darzustellen. Hierbei nutzt man die bekannte durch Bortrifluorid in Acetanhydrid herbeigeführte Acylierungsreaktion von Acetylverbindungen **VII** die zur Bildung der methylenaktiven 4-Methyl-6-(het)aryl-2,2-difluoro-1,3,2-dioxaborine **XIV** und **XVI** führt, welche mit beliebigen (Het)arylaldehyden, bevorzugt jedoch mit Verbindungen des Typs **IX,** in bisher unbekannte, langwellig emittierende Luminophore **XV** mit amorphen Eigenschaften umgewandelt werden.

Die Amorphizität der neuen Chromophore **XI, XII, XIII, XIV** und **XV** verbessert sich tendenziell mit Zunahme des Arylsubstitutionsgrades an den heteroaromatischen Grundkörpern. Sie lassen sich in Beschichtungsverfahren aus Lösungen und durch Verdampfung verarbeiten, wobei diese Emittermaterialien in einen Elektronentransportmaterial dotiert oder im Falle von Perarylsubstitution auch kombiniert als Emitter- und Elektronentransportmaterial eingesetzt werden können.

### Ausführungsbeispiele:

In den Beispielen 1 bis 14 werden die allgemeinen Synthesevorschriften der Substanzklassen an Einzelbeispielen erläutert, im Beispiel 15 wird der Aufbau einer Oled und deren physikalische Charakteristik dargestellt.

### Beispiel 1)

### Synthese der Carbonsäureamide II

In einem 2 1-Dreihalskolben mit Rückflusskühler, Magnetrührer, Tropftrichter und Inertgasdurchfluss wird jeweils 1 mol eines sekundären Amins I in 600 ml Dioxan gelöst. Das jeweils benötigte Carbonsäurehalogenid wird danach in äquivalenter Menge zugetropft. Anschließend wird das Reaktionsgemisch unter Rückfluss erhitzt, bis die gesamte Menge des bei der Reaktion entstehenden Hydrohalogenids vom Inertgasstrom entfernt worden ist. Durch dünnschichtchromatographische Kontrolle kann das Ende der Reaktion zusätzlich detektiert werden. Die Reaktionslösung wird dann abgekühlt und in mindestens die 2fache Menge Wasser eingerührt. Dabei scheidet sich in den meisten Fällen ein Öl ab, welches nach einigen Stunden erstarrt ist. Die wässrige Phase wird abgetrennt und das Rohprodukt aus Ethanol umkristallisiert.
Die Ausbeute beträgt jeweils mindestens 90%.

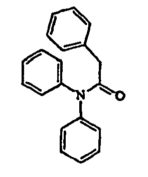

Auf diese Art wird beispielsweise 2-Phenylessigsäurediphenylamid (mp:71 -72°C) aus Diphenylamin und 2-Phenylacetylchlorid hergestellt.

### Beispiel 2

### Synthese der Thiocarbonsäureamiden IV

0,5 mol des jeweiligen Carbonsäureamids **II** und die äquivalente Menge Lawesson-Reagenz (hergestellt aus Anisol und Phosphorpentasulfid) werden in einer Rückflussapparatur mit Inertgasdurchfluss in 750 ml Diglykoldiethylether suspendiert, und dann wird 6 h bei 100°C gerührt. Dabei bildet sich eine klare Lösung, aus der in der Kälte in einigen Fällen das Reaktionsprodukt auskristallisiert. Um das Produkt vollständig zu isolieren, wird die Reaktionsmischung in die doppelte Menge Wasser eingerührt, die sich oft bildende ölige Phase lässt man dann kristallisieren. Danach wird das Produkt von der wässrigen Phase abgetrennt und aus Methanol umkristallisiert. Die Ausbeute beträgt jeweils mindestens 90%. 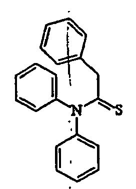 Auf diese Art wird beispielsweise 2-Phenylthioessigsäurediphenylamid (mp:142 - 144°C) aus 2-Phenylessigsäurediphenylamid und dem Lawesson-Reagenz hergestellt.

### Beispiel 3

### Synthese der Chlorpropeniminiumsalze III

0,5 mol des jeweiligen Carbonsäureamids **II** werden in einem 2 1-Becherglas in 1,5 mol DMF suspendiert. Zu dieser Suspension werden 1,25 mol POCl₃ so zugetropft, dass die Temperatur der Reaktionsmischung zwischen 50 und 60°C liegt; erforderlichenfalls wird mittels eines Eisbades gekühlt. Im Verlauf der Reaktion entsteht eine vollständige Lösung, die bis 30 min nach der POCl₃-Zugabe auf 60°C gehalten wird, und danach wird abkühlt. Zu der Reaktionslösung wird dann - zur Zersetzung des überschüssigen Vilsmeier-Reagenz - vorsichtig eine Mischung aus 0,5 mol 70%iger Perchlorsäure und Methanol gegeben. Die verwendete Methanolmenge sollte etwa dem doppelten Volumen der Reaktionslösung entsprechen. Das bei der Umsetzung gebildete Chlorvinyliminiumsalz fällt beim Abkühlen in Form des Perchlorats aus. Die Ausbeute beträgt jeweils mindestens 85%. 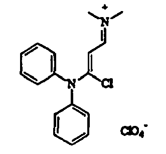 Auf diese Art wird beispielsweise 1-Chlor-1-diphenylamino-propen-3-yl-dimethyliminium-perchlorat (mp: 178 - 180°C) aus Essigsäure-diphenylamid und POCl₃ in DMF hergestellt.

### Beispiel 4

### Synthese der vinylogen Thiocarbonsäureamide V

### a) aus Thiocarbonsäureamiden IV

0,2 mol des jeweiligen Thiocarbonsäureamids **IV**, 0,8 mol Orthoameisensäuretriethylester und 0,6 mol Morpholin werden in einem Kolben, der mit Magnetrührer, Wasserabscheider und Rückflusskühler versehen ist, so lange bei 130°C erhitzt, bis sich im Wasserabscheider 0,6 mol Ethanol abgeschieden haben. Nach dem Abkühlen wird die Reaktionslösung in die 5fache Menge Wasser eingerührt, und dann wird mit Eisessig neutralisiert. Das auskristallisierte Produkt wird abgetrennt und aus Methanol umkristallisiert. Die Ausbeute beträgt jeweils mindestens 90%. 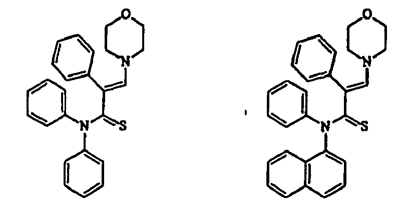 Auf diese Art wird beispielsweise 3-Morpholino-2-phenyl-thio-acrylsäurediphenylamid (mp: 182°C) aus 2-Phenylthioessigsäurediphenylamid in Gegenwart von Orthoameisensäure-triethylester und Morpholin hergestellt sowie 3-Morpholino-2-phenyl-thioacrylsäure-N-phenyl-N-1-naphthylamid (mp: 185°C) aus 2-Phenylthioessig-säure-N-phenyl-N-1-naphthylamid in Gegenwart von Orthoameisensäure-triethylester und Morpholin.

### b) aus Chlorpropeniminiumsalzen III

0,2 mol des jeweiligen Chlorvinyliminiumsalzes **III** und 0,2 mol Natriumthiosulfat werden in einer Rückflussapparatur in 500 ml Methanol suspendiert, dann wird bis zur Bildung einer klaren Lösung unter Rückfluss erhitzt. Das dabei entstandene Bunte-Salz IIIb wird durch Zugabe von 0,4 mol Anilin in das Anil des vinylogen Thiocarbonsäureamids V überführt, welches bereits in der Wärme zu kristallisieren beginnt und nach dem Abkühlen vollständig ausgefallen ist. Nach Zugabe von 100 ml Wasser wird das Produkt abgesaugt. Die Ausbeute beträgt jeweils mindestens 80%. 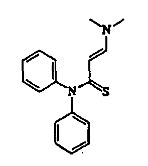 Auf diese Art wird beispielsweise 3-Dimethylamino-thioacrylsäurediphenylamid (mp: 185 - 187°C) aus 1-Chlor-1-diphenylamino-propen-3-yl-dimethyliminium-perchlorat hergestellt.

### Beispiel 5

### Synthese der Thienylcarbonsäureester VI

### a) aus vinylogen Thiocarbonsäureamiden V

0,1 mol des jeweiligen vinylogen Thiocarbonsäureamid **V** wird mit der äquivalenten Menge α-Halogenessigsäureester in 300 ml Ethanol in einem Kolben mit Rückflußkühler unter Rühren für 30 min am Rückfluß erwärmt. Dabei entsteht eine vollständige Lösung. Danach setzt man 0,1 mol Triethylamin zu und läßt nach weiteren 5 min abkühlen, wobei Triethylammoniumhalogenid ausfällt und das Produkt ausfällt. Man versetzt mit 100ml Wasser und saugt das kristallisierte Produkt ab, trocknet und kristallisiert aus Ethanol bzw. Ethanol/Wasser um. Die Ausbeuten betragen mindestens 80% d. T.

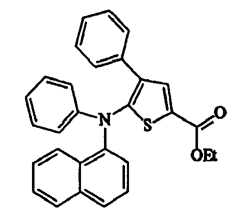

Auf diese Art wird beispielsweise 2-(N-1-Naphthyl-N-phenyl-amino)-3-phenylthien-5-yl-carbonsäureethylester VI/1 mp: 57°C hergestellt.

### b) aus Chlorpropeniminiumsalzen III

0,1 mol des jeweiligen Chlorpropeniminiumsalz **III** wird mit der äquivalenten Menge Mercaptoessigsäureester in 150ml Ethanol in einem Kolben mit Rückflußkühler unter Rühren für 30 min am Rückfluß erwärmt. Dabei entsteht eine vollständige Lösung. Danach setzt man 0,1 mol Triethylamin zu und läßt nach weiteren 5 min abkühlen, wobei Triethylammoniumhalogenid und das Produkt ausfällt. Man versetzt mit 100ml Wasser und saugt das kristallisierte Produkt ab, trocknet und kristallisiert aus Ethanol bzw. Ethanol/Wasser um. Die Ausbeuten betragen mindestens 80% d. T. 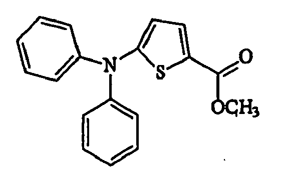 Auf diese Art wird beispielsweise 2-(N,N-Diphenyl)-amino-thien-5-yl-carbonsäuremethylester VI/2 mp: 55°C hergestellt.

### Beispiel 6

### Darstellung der Acetylthiophene VII

0,1 mol des jeweiligen vinylogen Thiocarbonsäureamid **V** wird mit der äquivalenten Menge Chloraceton in 150ml THF in einem Kolben mit Rückflußkühler unter Rühren für 30 min am Rückfluß erwärmt. Dabei entsteht eine vollständige Lösung. Danach setzt man 0,1 mol Triethylamin zu und läßt nach weiteren 5 min abkühlen, wobei Triethylammoniumhalogenid ausfällt. Aus der Reaktionsmischung wird THF am Rotationsverdampfer entfernt und danach mit 10ml Eisessig und 100ml Wasser versetzt. Das Produkt kristallisiert und wird abgesaugt, getrocknet und aus Ethanol bzw. Ethanol/Wasser umkristallisiert. Die Ausbeuten betragen mindestens 70% d. T.

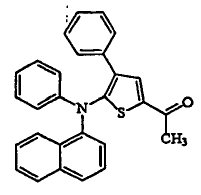

Auf diese Art wird beispielsweise 2-(N-1-Naphthyl-N-phenyl)-amino-3-phenyl-5-acetylthiophen VII/1 mp: 135 -137°C hergestellt.

### Beispiel 7

### Synthese der 2-Aminothiophene VIII

0,1 mol des jeweiligen Thiocarbonsäureamid **IV** wird mit der äquivalenten Menge einer aromatischen ω-Halogenacetylverbindung in 200ml DMF in einem Kolben mit Rückflußkühler unter Rühren für 5h auf 120°C erwärmt. Dabei entsteht eine vollständige Lösung. Danach läßt man abkühlen. Die Reaktionsmischung wird unter Rühren in 300g zerstoßenes Eis gegeben, wobei das Produkt kristallisiert. Schließlich wird abgesaugt, getrocknet und aus Ethanol umkristallisiert. Die Ausbeuten betragen mindestens 70% d. T. 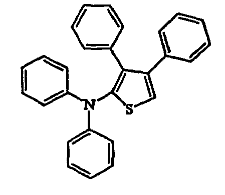 Auf diese Art wird beispielsweise 2-(N,N-Diphenyl)-amino-3,4-diphenyl-thiophen VIII/1 mp: 105°C hergestellt.

### Beispiel 8

### Synthese der 2-Amino-5-formylthiophene IX

0,1 mol des jeweiligen 2-Aminothiophen **VIII** wird in einem Becherglas mit 50 ml DMF digeriert und gekühlt, so daß bei der tropfenweisen Zugabe von 0,15 mol POCl₃ die Temperatur 20°C nicht übersteigt. Dabei entsteht eine vollständige Lösung, die nach Beendigung der Zugabe noch einmal für 30 min auf 60°C erwärmt wird. Die Reaktionsmischung wird dann unter Rühren in 300g zerstoßenes Eis gegeben, wobei das Produkt kristallisiert. Schließlich wird abgesaugt, getrocknet und aus Ethanol umkristallisiert. Die Ausbeuten betragen mindestens 60% d. T. 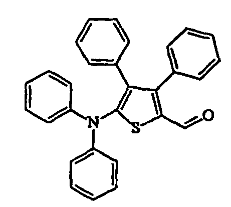 Auf diese Art wird beispielsweise 2-(N,N-Diphenylamino)-3,4-diphenyl-5-formylthiophen IX/1 mp: 116°C hergestellt.

### Beispiel 9

### Synthese der Dithienylpropan-1,3-dione Xa

### a) aus vinylogen Thiocarbonsäureamiden V

Eine Mischung aus einem vinylogen Thiocarbonsäureamid **V** (0,002 mol) und 1,5-Dichlor-pentan-2,4-dion (0,001 mol) in Acetonitril (50 mL) wird kurz auf dem Wasserbad erwärmt und anschließend mit Triethylamin (1 ml) versetzt. Das beim Erkalten nach Zugabe von Wasser (10 ml) ausfallende Produkt wird abgesaugt und an der Luft getrocknet.
Auf diese Art wird beispielsweise die Verbindung des Typs Xa erhalten:
- 1,3-Bis-(2-diphenylamino-thien-5-yl)-propan-1,3-dion in einer Ausbeute von 71% und einem mp = 302 °C;

| | | | |
|---|---|---|---|
| | 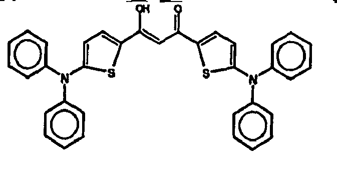 | λₘₐₓ | λ_{F} |
| **Xa/1** | | 440nm | 529nm |

### b) aus Thienylcarbonsäureestern VI und Acetylthiophenen VII

Zu einer Suspension aus Natriumhydrid (0,12 mol) in Toluol (250 ml) wird unter Rühren eine Mischung aus einem Thienylcarbonsäureester **VI** (0,1 mol) und einem Acetylthiophen **VII** (0,1 mol) getropft. Anschließend wird 10 h unter Rückfluß erhitzt und nach dem Erkalten die Reaktionsmischung in wässrige Essigsäure gegossen. Das ausfallende Produkt wird abgesaugt und aus Eisessig oder Essigester umkristallisiert.
Auf diese Art wird beispielsweise die gleiche Verbindung des Typs **Xa** erhalten:
- 1,3-Bis-(2-diphenylaminothien-5-yl)-propan-1,3-dion in einer Ausbeute von 56% und einem mp: 302 °C

| | | | |
|---|---|---|---|
| | 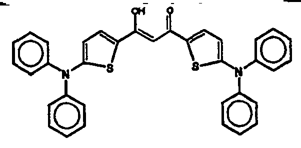 | λₘₐₓ | λ_{F} |
| **Xa/1** | | 440nm | 529nm |

### Beispiel 10

### Synthese der 1,3-Diketoderivaten Xb -Xd

### a) aus Thienylcarbonsäureestern VI und einem Acetylderivat VIIb - VIId

Zu einer Suspension aus Natriumhydrid (0,12 mol) in Toluol (250 ml) wird unter Rühren eine Mischung aus einem Thienylcarbonsäureester **VI** (0,1 mol) und einem Acetylderivat **VIIb** (0,1 mol); **VIIc** (0,05 mol) und **VIId** (0,033 mol) getropft. Anschließend wird 10 h im Falle von **VIIb** bzw. 48h im Falle von **VIIc** und **VIId** unter Rückfluß erhitzt und nach dem Erkalten die Reaktionsmischung in wässrige Essigsäure gegossen. Das ausfallende Produkt wird abgesaugt und aus Eisessig oder Essigsäureethylester umkristallisiert.

Auf diese Art werden beispielsweise folgende Synthons **Xb - Xd** hergestellt.

| | | | | | |
|---|---|---|---|---|---|
| | 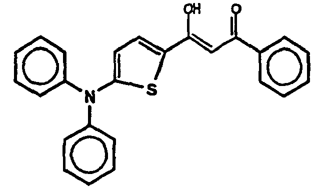 | λₘₐₓ | λ_{F} | mp | Ausbeute |
| **Xb/1** | | 441nm | 528nm | 132°C | 32% |
| | | | | | |
| | 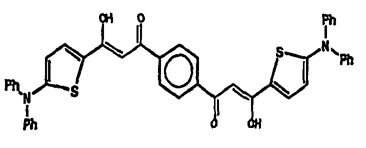 | λₘₐₓ | λ_{F} | mp | Ausbeute |
| **Xc/1** | | 452nm | 544nm | 220°C | 15% |
| | | | | | |
| | 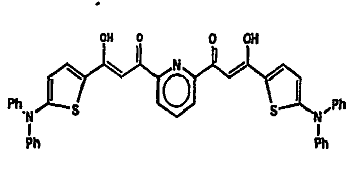 | λₘₐₓ | λ_{F} | mp | Ausbeute |
| **Xc/2** | | 443nm | 547nm | 226°C | 34% |
| | | | | | |
| | 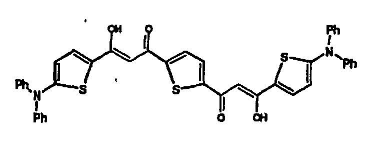 | λₘₐₓ | λ_{F} | mp | Ausbeute |
| **Xc/3** | | 361nm | 449nm | 156°C | 32% |
| | | | | | |
| | 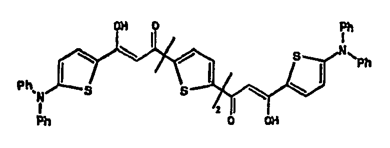 | λₘₐₓ | λ_{F} | mp | Ausbeute |
| **Xc/4** | | 377nm | 487nm | 195°C | 28% |
| | | | | | |
| | 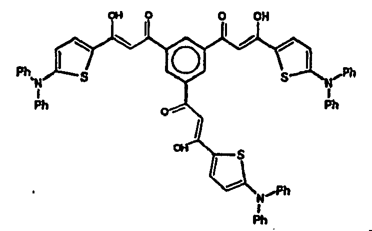 | λₘₐₓ | λ_{F} | mp | Ausbeute |
| **Xd/1** | | 447nm | 544nm | 262°C | 38% |

### b) aus Acetylthiophenen VII und einem Esterderivat VIb -VId

Zu einer Suspension aus Natriumhydrid (0,24 mol) in Toluol (350 ml) wird unter Rühren eine Mischung aus einem Acetylthiophen VII (0,2 mol) und einem Esterderivat VIb (0,2 mol); VIc (0,1 mol); VId (0,067 mol) getropft. Anschließend wird 48 h unter Rückfluß erhitzt und nach dem Erkalten die Reaktionsmischung in wässrige Essigsäure gegossen. Das ausfallende Produkt wird abgesaugt und aus Eisessig oder Essigsäureethylester umkristallisiert.

Auf diese Art wird beispielsweise die Verbindung **Xc/1** (R¹, R² = Phenyl, R³ = H, R⁸ = chemische Bindung) in einer Ausbeute von 59%; mp: 205 - 207°C hergestellt.

| | | | |
|---|---|---|---|
| | 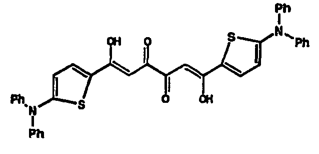 | λₘₐₓ | λ_{F} |
| **Xc/1** | | 492nm | 599nm |

### Beispiel 11

### Synthese von 1,3,2-Dioxaborinen XI und XII

Eine Mischung eines 1,3-Diketoderivats **X** (0,001 mol) in Acetanhydrid (100 mL) wird mit einem Borsäure-Derivat (0,002 mol) Essigsäure-Bortrifluorid-Komplex bzw. Bortriacetat für **XIa, XIIa, XIb und XIIb;** (0,004 mol)Essigsäure-Bortrifluorid-Komplex bzw. Bortriacetat für **XIc** und **XIIc** und (0,006 mol) Essigsäure-Bortrifluorid-Komplex bzw. Bortriacetat für **XId** und **XIId** versetzt und anschließend 30 min unter Rückfluß erhitzt. Nach dem Erkalten wird vom ausgefallenem Produkt abgesaugt und zur Reinigung aus Eisessig umkristallisiert.

Auf diese Art werden beispielsweise folgende 1,3,2-Dioxaborine **XI** und **XII** hergestellt.

| | | | | | |
|---|---|---|---|---|---|
| | 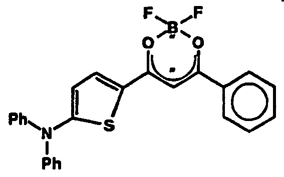 | λₘₐₓ | λ_{F} | mp Tg | Ausbeute |
| **XIb/1** | | 501nm | 606nm | 258°C 99°C | 40% |
| | | | | | |
| | 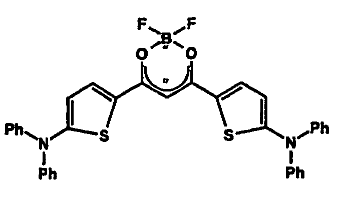 | λₘₐₓ | λ_{F} | mp Tg | Ausbeute |
| **XIa/1** | | 566nm | 622nm | 302°C | 37% |
| | | | | 94°C | |
| | | | | | |
| | 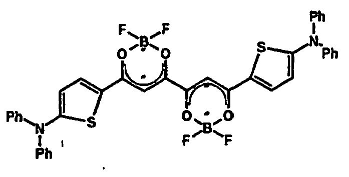 | λₘₐₓ | λ_{F} | mp | Ausbeute |
| **XIc/1** | | 629nm | 725nm | >360° C | 45% |
| | | | | | |
| | 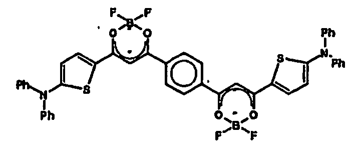 | λₘₐₓ | λ_{F} | mp | Ausbeute |
| **XIc/2** | | 554nm | 654nm | >360° C | 30% |
| | | | | | |
| | 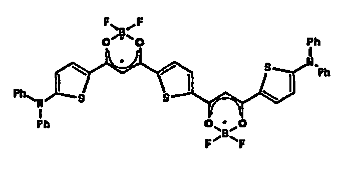 | λₘₐₓ | λ_{F} | mp | Ausbeute |
| **XIc/3** | | 538nm | 627nm | 262°C | 34% |
| | | | | | |
| | 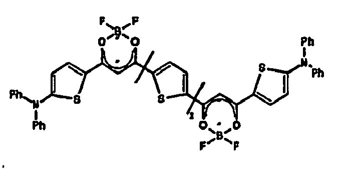 | λₘₐₓ | λ_{F} | mp | Ausbeute |
| **XIc/4** | | 561nm | 661nm | 261°C | 38% |
| | 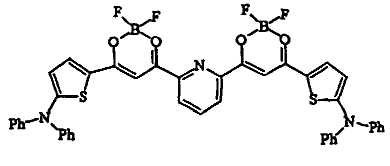 | λₘₐₓ | λ_{F} | mp | Ausbeute |
| **XIc/5** | | 505nm^{c)} | 610nm^{c)} | >360° C | 41% |
| | | | | | |
| | 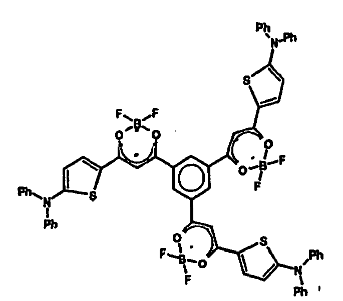 | λₘₐₓ | λ_{F} | mp | Ausbeute |
| **XId/1** | | 530nm^{a)} | 639nm^{a)} | >360° C | 33% |
| | | | | | |
| | 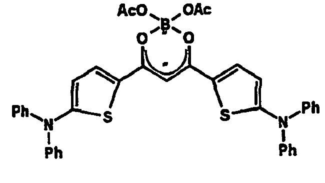 | λₘₐₓ | λ_{F} | mp Tg | Ausbeute |
| **XI-Ia/1** | | 566nm | 613nm | 234 47 | 65% |

### Beispiel 12

### Synthese der 1,3,2-Dioxaborinen XIII

Eine Mischung eines 2,2-Diacetyl-1,3,2-Dioxaborin **XII** (0,001 mol) in Dichlorethan (100 mL) wird mit Oxalsäure (0,002 mol) für **XIIIa** und **XIIIb;** (0,004 mol) für **XIIIc** und (0,006 mol) für **XIIId** versetzt und anschließend 30 min unter Rückfluß erhitzt. Nach dem Erkalten wird vom ausgefallenen Produkt abgesaugt und zur Reinigung aus Eisessig umkristallisiert.

Auf diese Art wird beispielsweise das 2,2-Oxalato-1,3,2-Dioxaborin **XIIIa/1** hergestellt.

| | | | | | |
|---|---|---|---|---|---|
| | 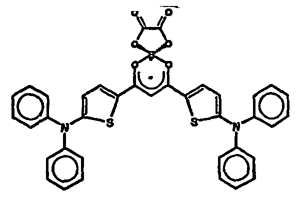 | λₘₐₓ | λ_{F} | mp | Ausbeute |
| **XIIIa/1** | | 595nm | 650nm | 338°C | 88% |

### Beispiel 13

### Synthese von 4-Methyl-1,3,2-dioxaborinen XIV und XVI

Eine Mischung einer (het)aromatischen Acetylverbindung **VII, VIIb, VIIc** oder **VIId** (0,1 mol) in Acetanhydrid (0,6 mol) wird mit Bortrifluorid-Essigsäure-Komplex (0,2 mol) für **VII** und **VIIb;** (0,4 mol) für **VIIc** und (0,6 mol) für **VIId** versetzt und anschließend 3h auf 45°C erwärmt. Nach dem Erkalten wird vom ausgefallenen Produkt abgesaugt und zur Reinigung das Rohprodukt aus Eisessig umkristallisiert, in einigen Fällen aber auch über Kieselgel mit Toluol/Eisessig chromatographisch abgetrennt.

Auf diese Art werden beispielsweise folgende 2,2-Difluoro-1,3,2-dioxaborine **XIV/XVI** hergestellt.

| | | | | | |
|---|---|---|---|---|---|
| | 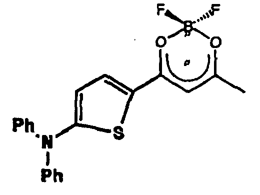 | λₘₐₓ | λ_{F} | mp | Ausbeute |
| **XIV/1** | | 418nm | 540nm | 201°C | 45% |
| | | | | | |
| | 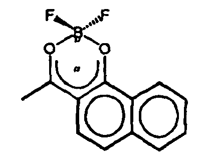 | λₘₐₓ | λ_{F} | mp | Ausbeute |
| **XVIa/1** | | 414nm^{b)} | 483nm^{b)} | 200°C | 33% |
| | 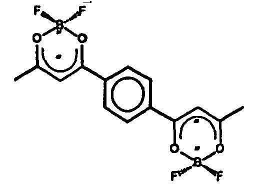 | λₘₐₓ | λ_{F} | mp | Ausbeute |
| **XVIb/1** | | 363nm | 417nm | 305°C | 88% |
| | | | | | |
| | 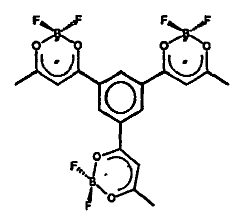 | λₘₐₓ | λ_{F} 380nm | mp | Ausbeute |
| **XVIc/1** | | 336nm | 409nm | 351°C | 49% |
| | | | 436nm | | |

### Beispiel 14

### Synthese der vinylogen 1,3,2-Dioxaborine XV

Eine Mischung aus einem 4-Methyl-substituierten 2,2-Difluoro-1,3,2-dioxaborin **XIV** bzw. **XVIa, XVIb** oder **XVIc** (0,001 mol) und der equivalenten Menge eines N,N-disubstituierten 2-Aminothiophen-5-carbaldehyds oder einer gleichen Menge seines zugehörigen Iminiumsalzes in Acetanhydrid (50 mL) wird auf dem Wasserbad 30 min erhitzt. Anschließend läßt man Abkühlen, wobei die Kristalle der Farbstoffe ausfallen, man saugt ab und wäscht mit Essigsäureethylester und Ether.
Auf diese Art werden beispielsweise folgende vinyloge 2,2-Difluoro-1,3,2-dioxaborine **XV** hergestellt.

| | | | | | |
|---|---|---|---|---|---|
| | 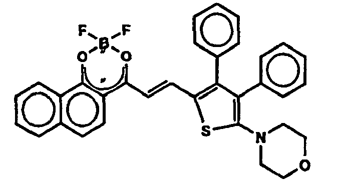 | λₘₐₓ | λ_{F} | mp | Ausbeute |
| **XVb/1** | | 604nm | 642nm | 171°C | 90% |
| | 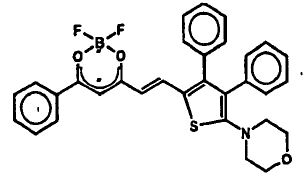 | λₘₐₓ | λ_{F} | mp | Ausbeute |
| **XVb/2** | | 565nm | 642nm | 168°C | 35% |
| | | | | | |
| | 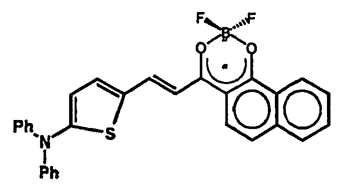 | λₘₐₓ | λ_{F} | mp | Ausbeute |
| **XVb/3** | | 604nm | 670nm | 287 | 75% |
| | | | | | |
| | 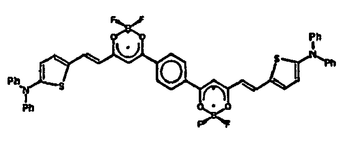 | λₘₐₓ | λ_{F} | mp | Ausbeute |
| **XVc/1** | | 648nm | 758nm | 319 | 85% |
| | | | | | |
| | 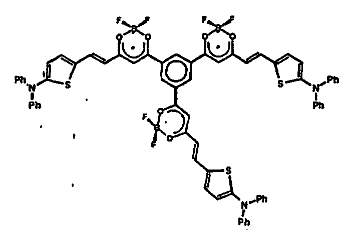 | λₘₐₓ | λ_{F} | mp | Ausbeute |
| **XVd/1** | | 634nm | 692nm | >360° C | 86% |

Zur Bestimmung der spektroskopischen Daten wurden die Farbstoffe in folgenden Lösungsmitteln vermessen:
ohne Anmerkung in CH₂Cl₂
a) in DMF
b) in CHCl₃
c) in Aceton

### Beispiel 15

### Charakteristik einer OLED mit dem Emittermaterial XIa/1

Die OLED wurde durch folgende Schichtreihenfolge aufgebaut:
Anode: ITO (Indium-Zinnoxid)
5nm CuPc (Cu-Phthalocyanin)
55nm 1-Naphdata [4,4',4' -(1-naphthyl-phenylamino)-triphenylamin]
5nm α NPD (N,N'Di-1-naphthyl-N,N'diphenylbenzidin)
30nm Alq₃ + 1,4% XIa/1
30nm Alq₃ (Aluminium-8-Hydroxychinolat)
0, 5nm LiF (Lithiumfluorid)
Kathode 150nm Al

### a) Stromdichte

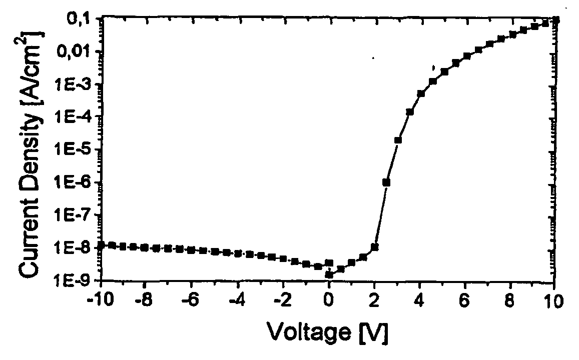

### b) Effizienz

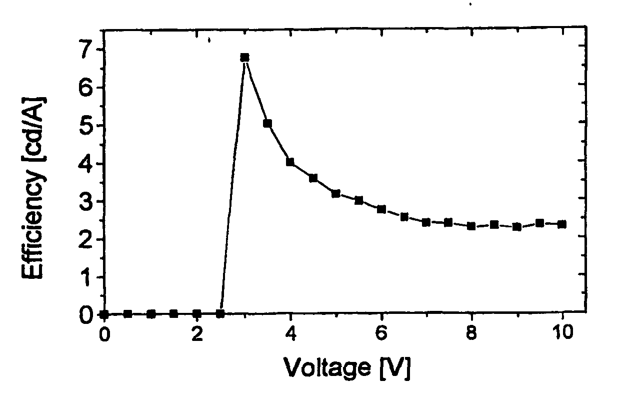

### c) CIE-Daten der OLED: (0,64 x 0,32 bei 0,25mA/cm²)

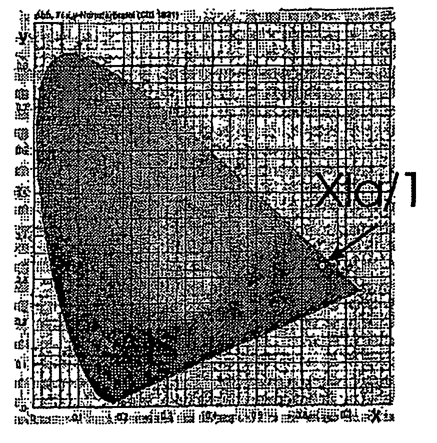

## Patentansprüche

1. 1,3,2-Dioxaborinluminophore der Typen **XI** 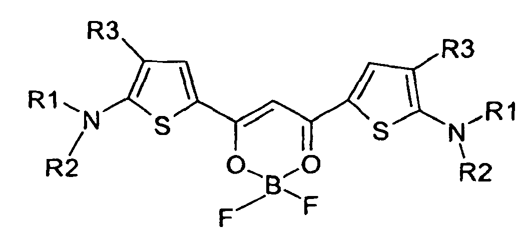 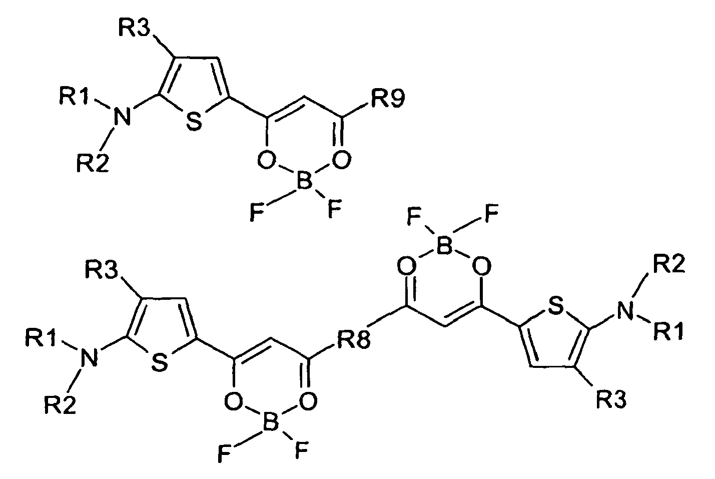 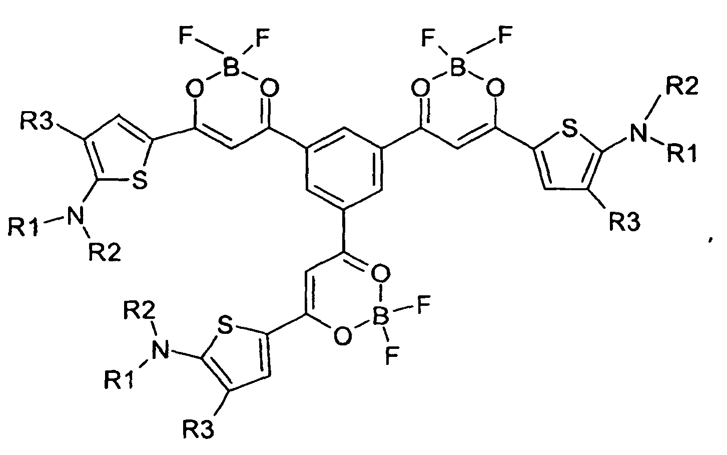 der Typen **XII** 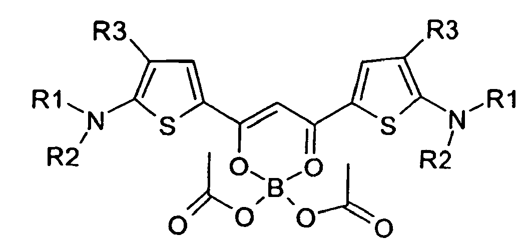 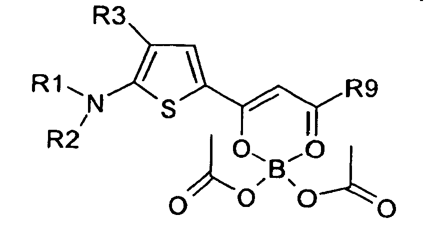 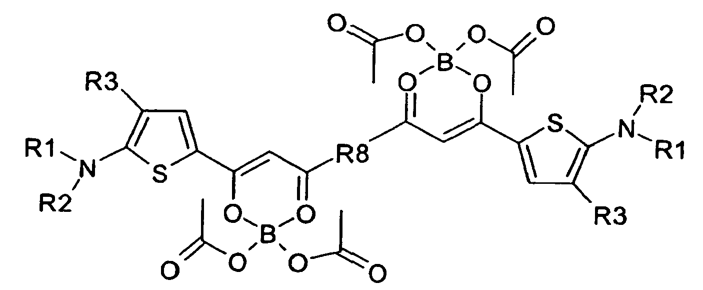 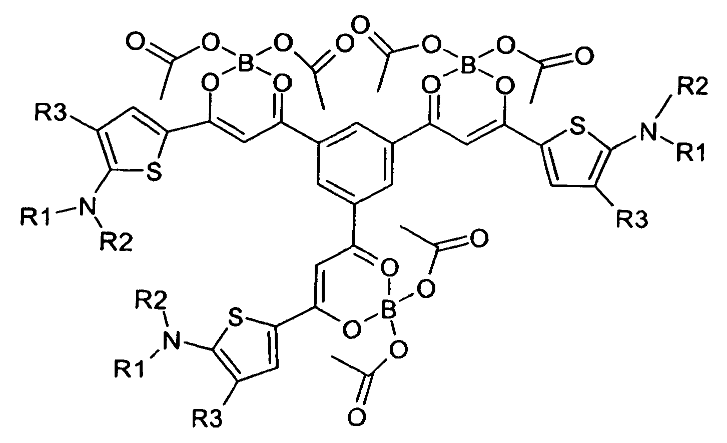 der Typen **XIII,** 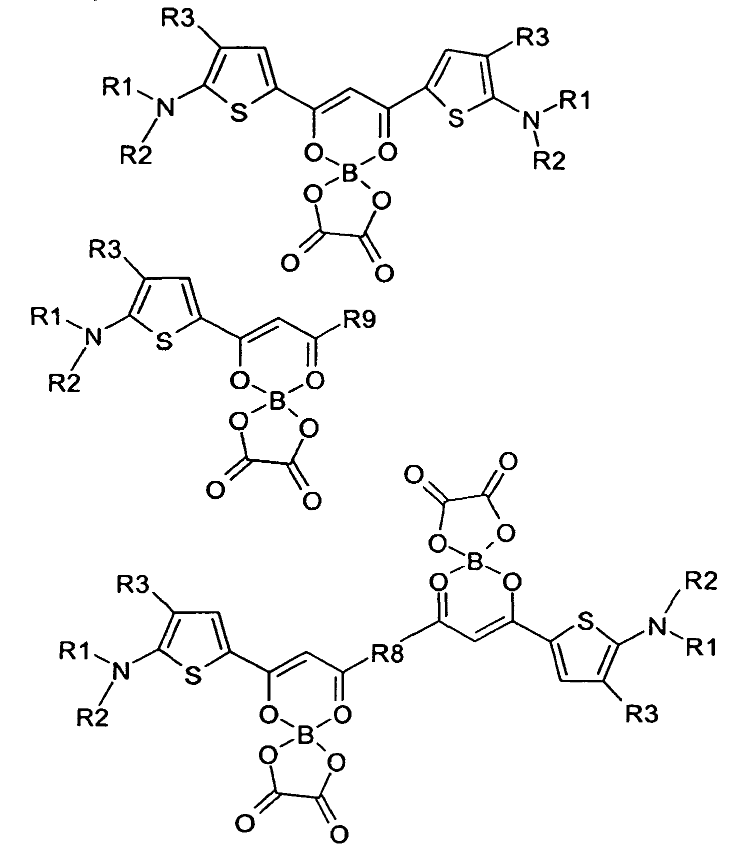 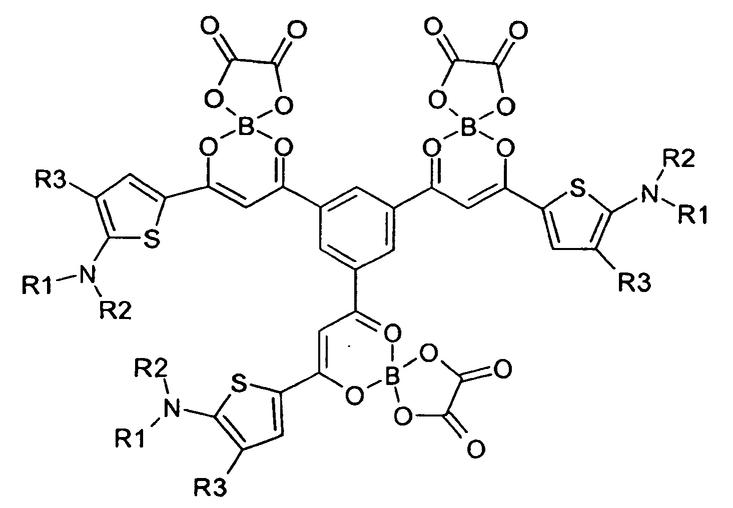 des Typs **XIV** 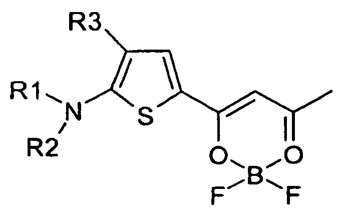 und/oder der Typen **XV** 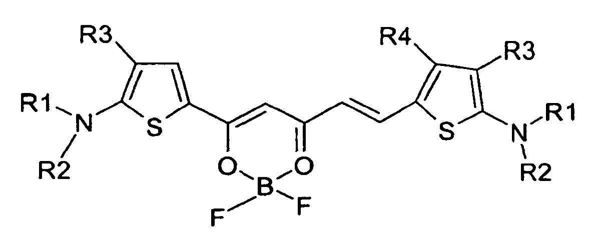 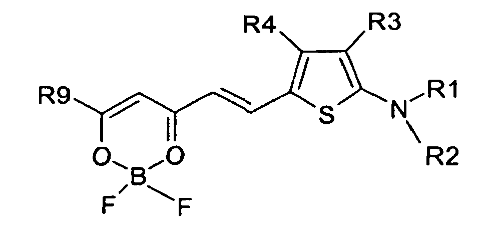 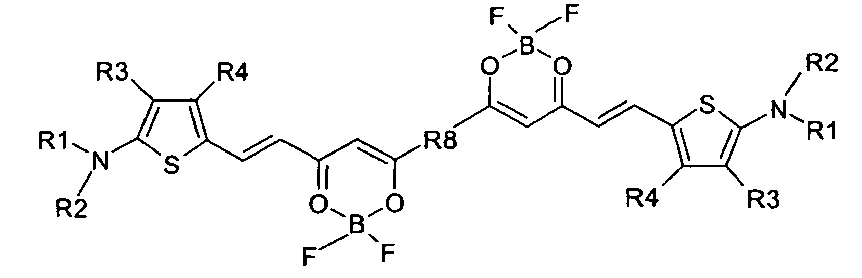 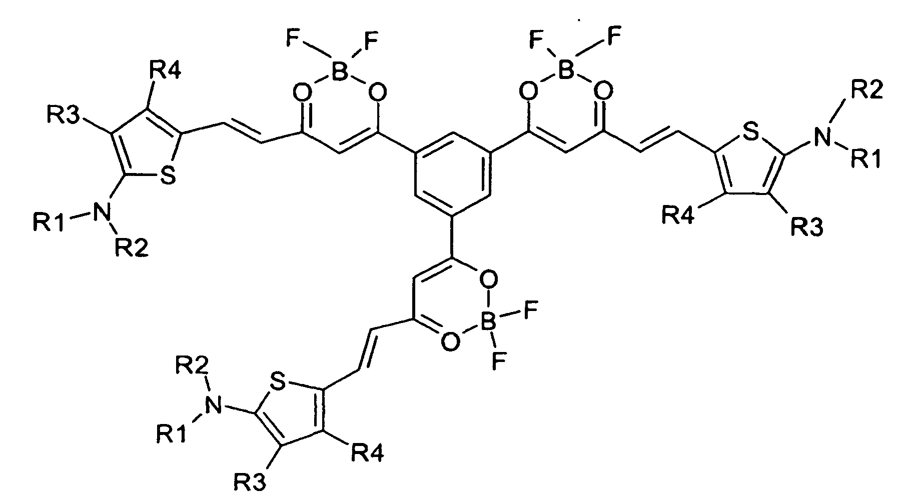 wobei Folgendes gilt:
R¹, R², R³, R⁴ und R⁹ sind - unabhängig voneinander - jeweils ein monofunktionelles (Het)arylsystem, d.h. ein konjugiertes carbocyclisches oder heterocyclisches Ringsystem, das auch aus linear oder angular anellierten oder verknüpften gleichen oder unterschiedlichen Ringtypen bestehen kann, wobei die peripheren Wasserstoffatome gegebenenfalls durch Alkyl-, Alkoxy-, Phenoxy-, Dialkylamino- oder Diphenylaminogruppen (Alkyl = C₁ bis C₆) substituiert sein können;
darüberhinaus können R¹ und R² im Verbindungstyp **XV** auch verzweigte oder unverzweigte Alkylgruppierungen (C₁-C₆) sein oder mit dem gebundenen N-Atom gemeinsam einen Pyrrolidin-, Piperidin- oder Morpholinring bilden;
R³ und R⁴ können ferner auch unabhängig voneinander H sein;
R⁸ kann eine chemische Bindung oder ein entsprechendes bifunktionelles (Het)arylensystem sein, d.h. ein konjugiertes carbocyclisches oder heterocyclisches Ringsystem, das auch aus linear oder angular anellierten oder verknüpften gleichen oder unterschiedlichen Ringtypen bestehen kann, wobei die peripheren Wasserstoffatome gegebenenfalls durch Alkyl-, Alkoxy-, Phenoxy-, Dialkylamino- oder Diphenylaminogruppen (Alkyl = C₁ bis C₆) substituiert sein können.

2. Verfahren zur Herstellung der 1,3,2-Dioxaborinluminophore **XI, XII** und **XIII** durch Umsetzung von 1,3-Diketoderivaten in Acetanhydrid mit einem Borsäurederivat.

3. Verfahren nach Anspruch 2, wobei durch eine Liganden-austauschreaktion zwei Acetatliganden an einem 1,3,2-Dioxaborinluminophor durch einen zweizähnigen Liganden, wie eine Dicarbonsäure, ersetzt werden.

4. Verfahren nach einem der Ansprüche 2 oder 3, bei dem eine Acetylverbindung durch die Acylierungsreaktion mit Bortrifluorid in Acetanhydrid in das methylenaktive 4-Methyl-6-(het)aryl-2,2-difluoro-1,3,2-dioxaborin **XIV/XVI** überführt wird und in einem anschließenden Reaktionsschritt aus der methylenaktiven Verbindung mit einem beliebigen Arylaldehyd die vinylogen 1,3,2-Dioxaborinluminophore **XV** erhalten werden.

5. Verfahren nach Anspruch 4, bei dem die Acetylverbindung ein 2-N,N-disubstituiertes Aminothien-5-yl-acetophenon **VII** und/oder der Arylaldehyd ein 2-N,N-disubstituiertes Amino-5-formyl-thiophen **IX** ist.

6. Verwendung eines 1,3,2-Dioxaborinluminophors der Typen **XI, XII, XIII, XIV** und/oder **XV** in einer organischen Leuchtdiode.

7. Verwendung eines 1,3,2-Dioxaborinluminophors der Typen **XI, XII, XIII, XIV** und/oder **XV** in einem elektronischen Bauelement mit einer organischen Funktionsschicht, wie in einer Solarzelle, in einem organischen Feld-Effekt-Transistor und/oder einem photorefraktiven Bauelement.

## Claims

1. 1,3,2-Dioxaborin luminophores of the types XI 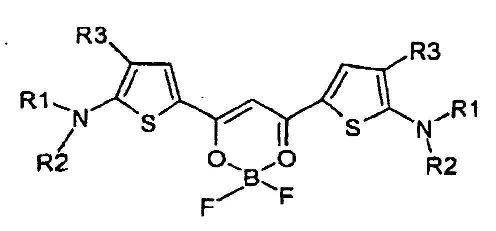 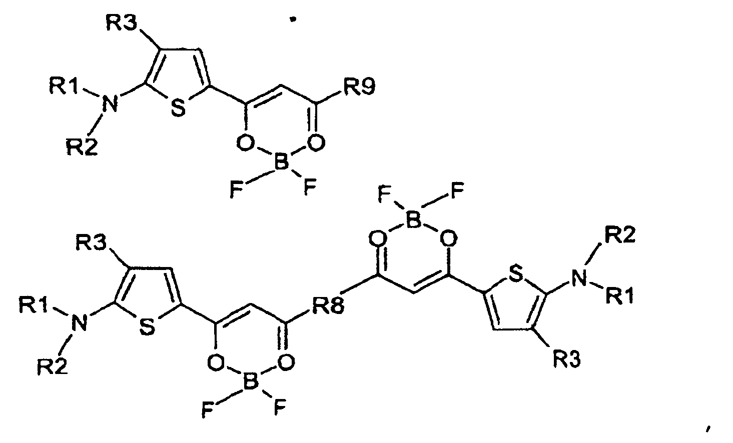 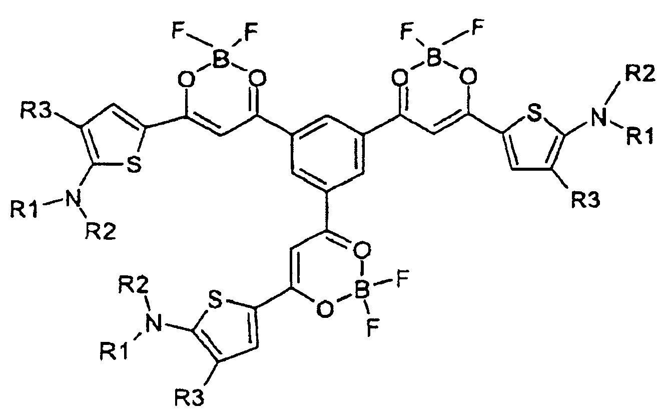 of the types XII 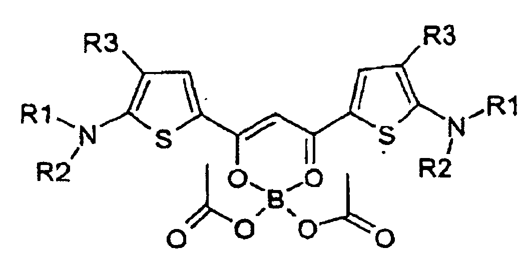 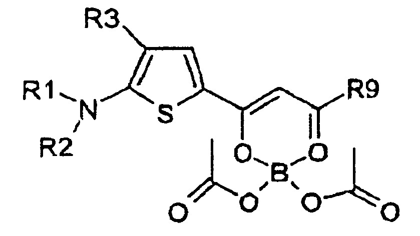 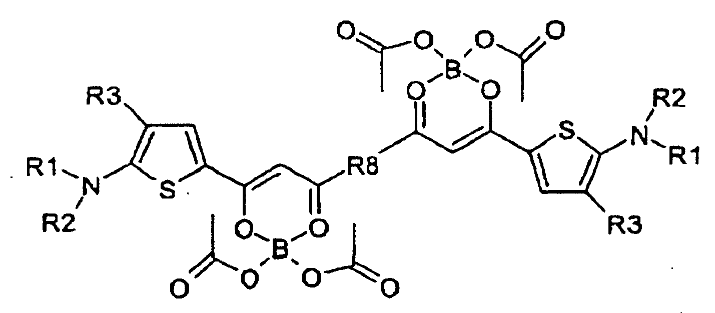 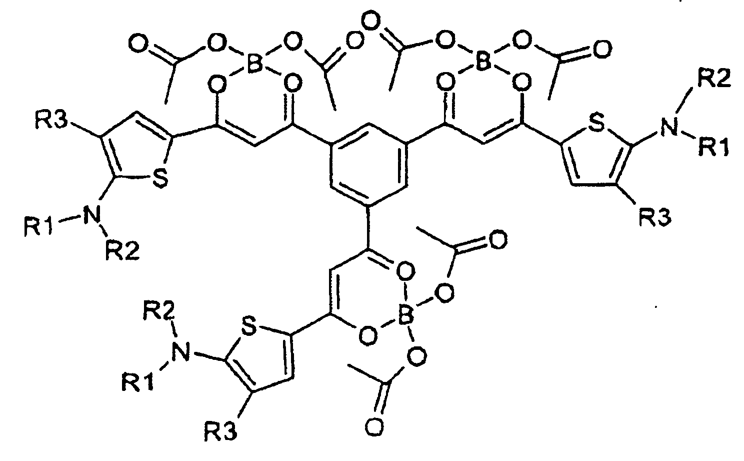 of the types XIII 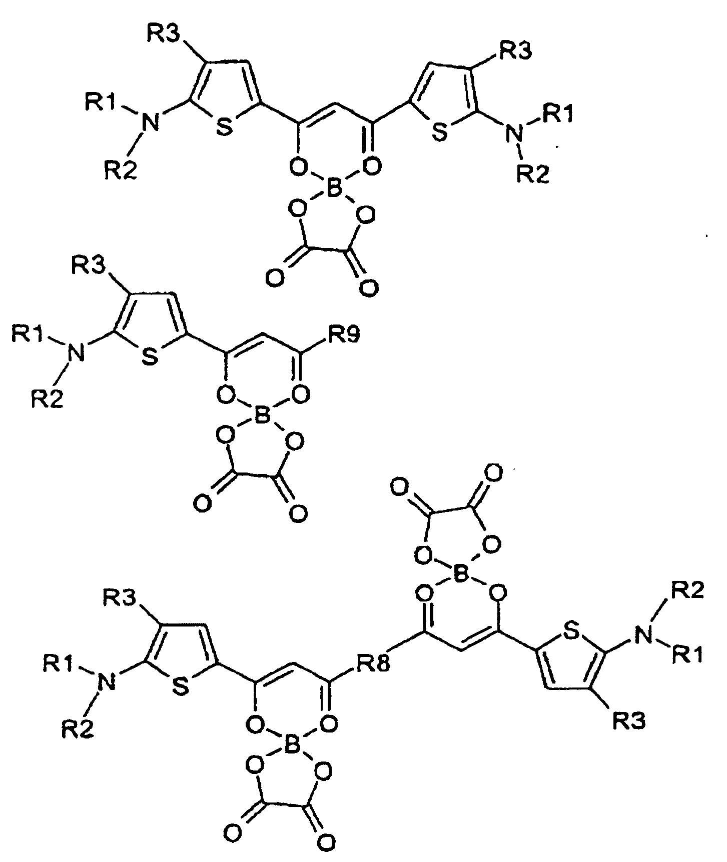 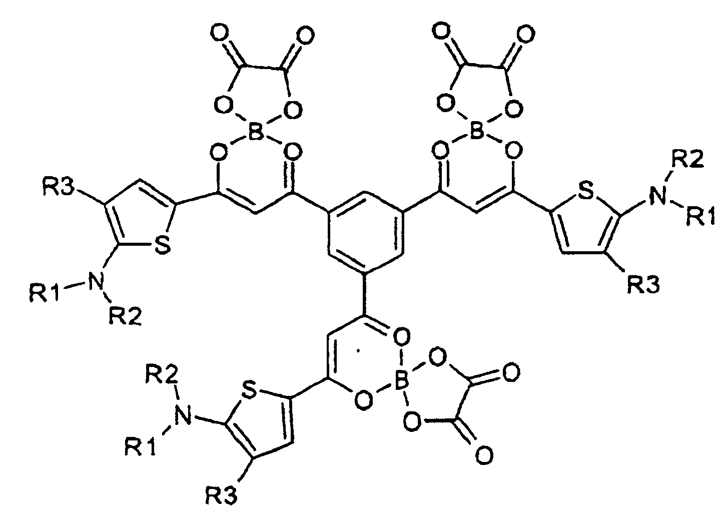 of the type XIV 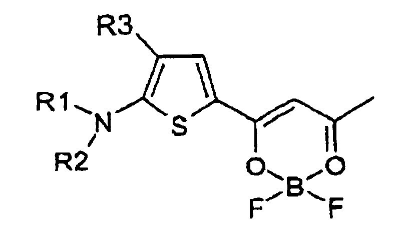 and/or of the types XV 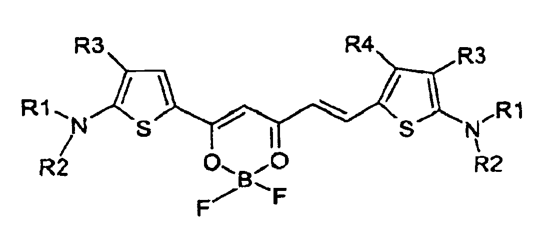 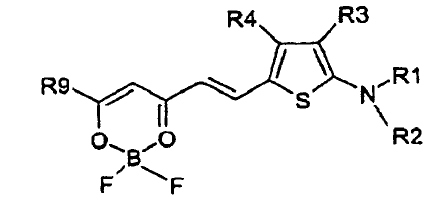 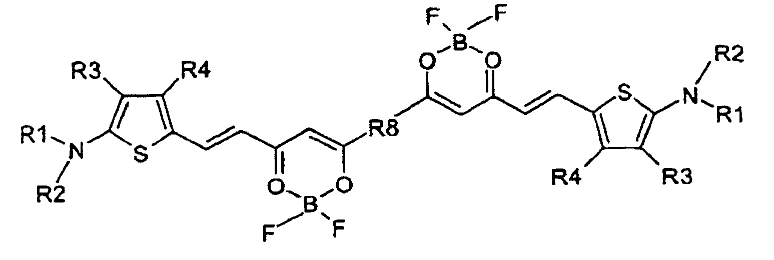 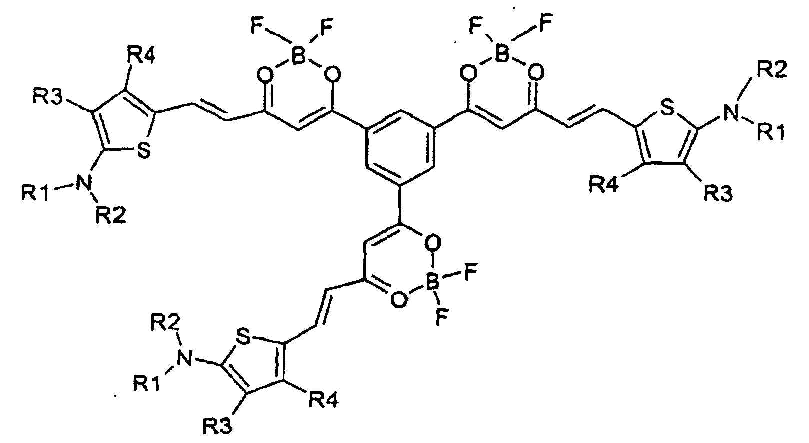 where:
R¹, R², R³, R⁴ and R⁹ are each independently a monofunctional (het) aryl system, i.e. a conjugated carbocyclic or heterocyclic ring system, which may also consist of linearly or angularly fused or joined, identical or different ring types, the peripheral hydrogen atoms optionally being substituted by alkyl, alkoxy, phenoxy, dialkylamino or diphenylamino groups (alkyl = C₁ to C₆) ;
additionally, R¹ and R² in the compound XV may also be branched or unbranched alkyl moieties (C₁-C₆) or, together with the bonded nitrogen atom, may form a pyrrolidine, piperidine or morpholine ring;
R³ and R⁴ may also each independently be H;
R⁸ may be a chemical bond or a corresponding bifunctional (het)arylene system, i.e. a conjugated carbocyclic or heterocyclic ring system, which may also consist of linearly or angularly fused or linked, identical or different ring types, the peripheral hydrogen atoms optionally being substituted by alkyl, alkoxy, phenoxy, dialkylamino or diphenylamino groups (alkyl = C₁ to C₆).

2. Process for preparing the 1,3,2-dioxaborin luminophores XI, XII and XIII by reacting 1,3-diketo derivatives in acetic anhydride with a boric acid derivative.

3. Process according to Claim 2, wherein a ligand exchange reaction replaces two acetate ligands on a 1,3,2-dioxaborin luminophore with a bidentate ligand such as a dicarboxylic acid.

4. Process according to one of Claims 2 or 3, in which an acetyl compound is converted by the acylation reaction with boron trifluoride in acetic anhydride to the methylene-active 4-methyl-6-(het)aryl-2,2-difluoro-1,3,2-dioxaborin XIV/XVI, and, in a subsequent reaction step, the vinylogous 1,3,2-dioxaborin luminophores XV are obtained from the methylene-active compound with any arylaldehyde.

5. Process according to Claim 4, in which the acetyl compound is a 2-N,N-disubstituted aminothien-5-yl-acetophone VII and/or the arylaldehyde is a 2,N,N-disubstituted amino-5-formylthiophene IX.

6. Use of a 1,3,2-dioxaborin luminophore of the types XI, XII, XIII, XIV and/or XV in an organic light-emitting diode.

7. Use of a 1,3,2-dioxaborin luminophore of the types XI, XII, XIII, XIV and/or XV in an electronic component with an organic functional layer, as in a solar cell, in an organic field-effect transistor and/or photorefractive component.

## Revendications

1. Luminophores 1,3,2-dioxaborine du type XI 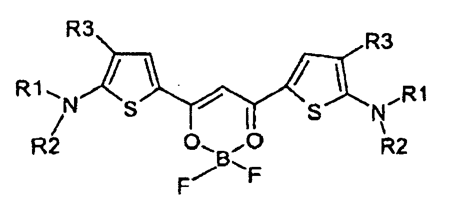 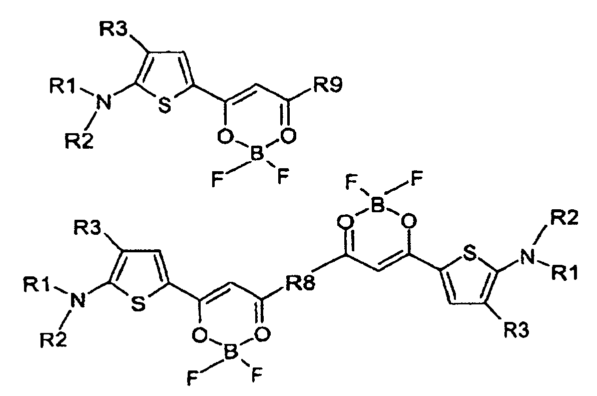 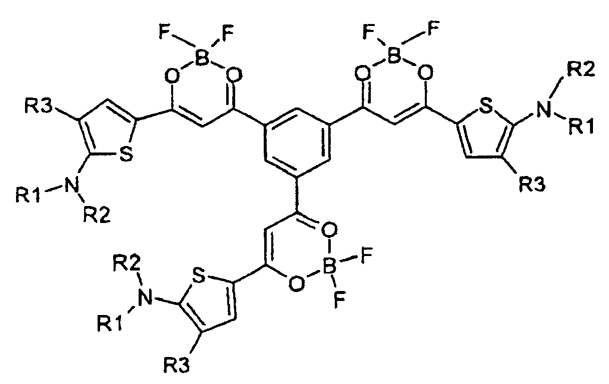 du type XII 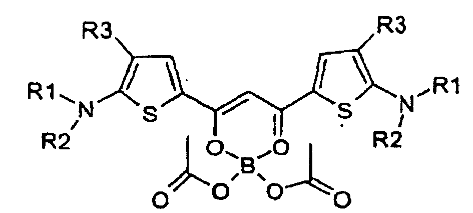 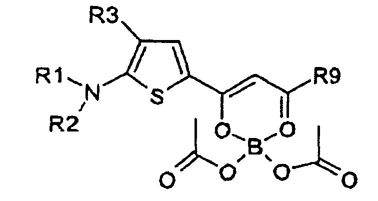 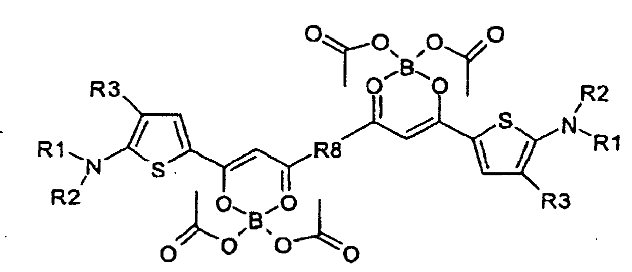 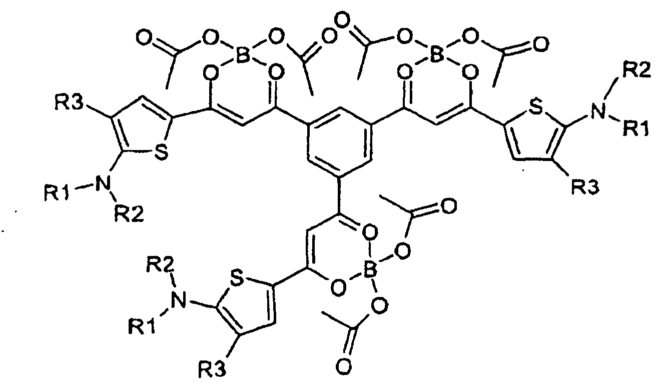 du type XIII 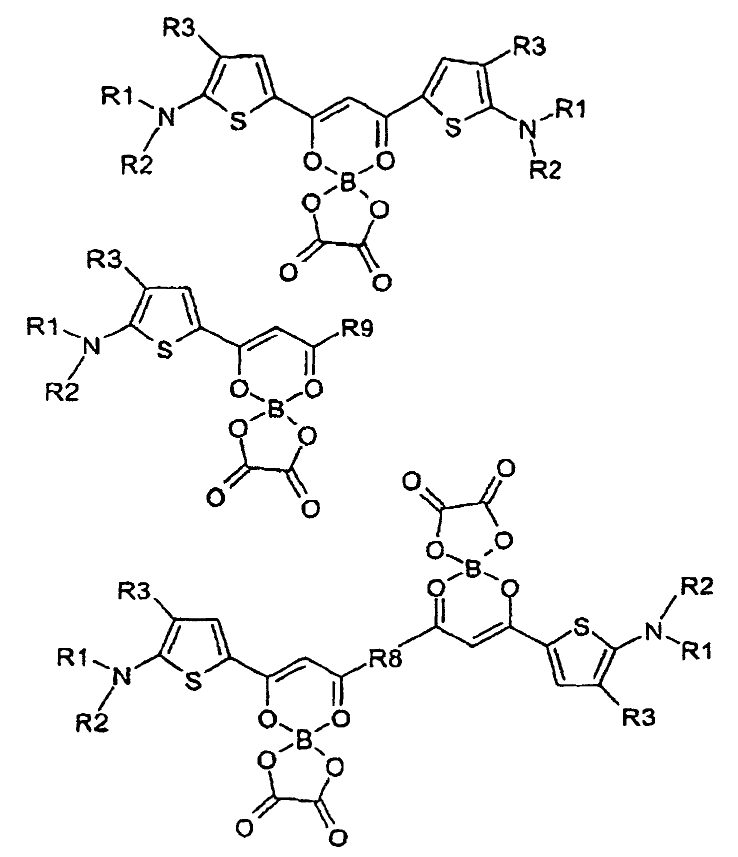 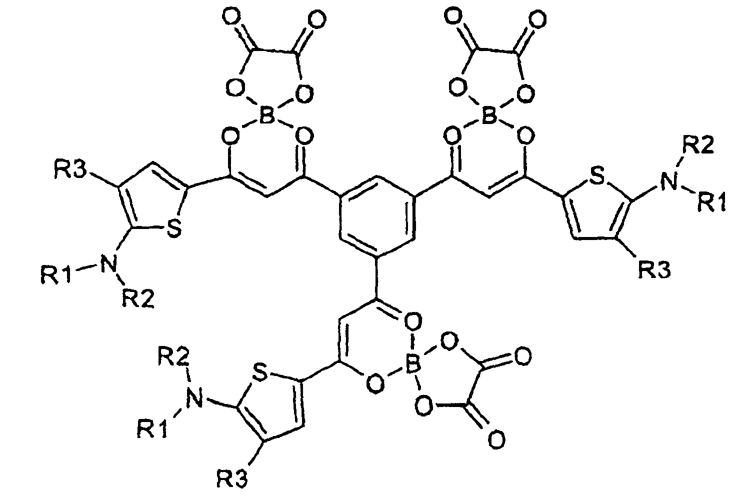 du type XIV 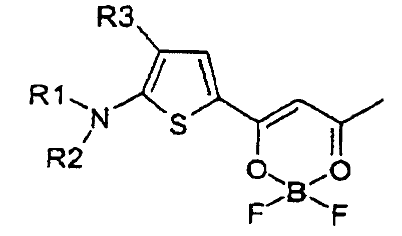 et/ou du type XV 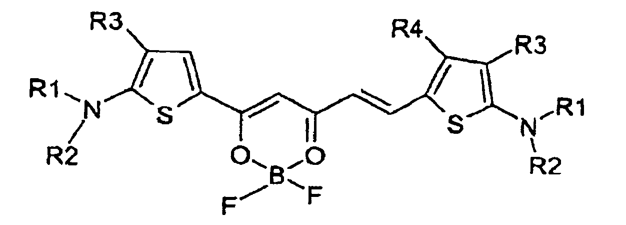 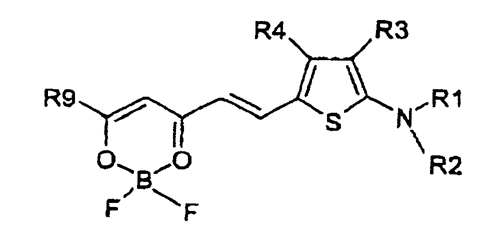 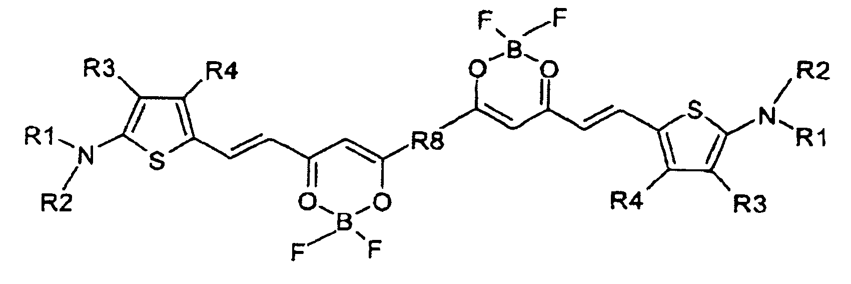 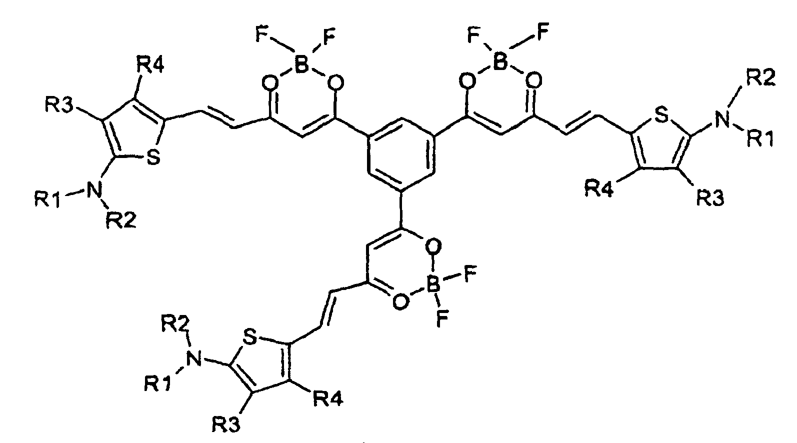 dans lesquels :
R¹, R², R³, R⁴ et R⁹ sont - indépendamment les uns des autres - chacun un système (Hét)arylique monofonctionnel, c'est-à-dire un système de noyau carbocyclique ou hétérocyclique conjugué, qui peut être constitué des types de noyau identiques ou différents, condensés ou liés de façon linéaire ou angulaire, où les atomes d'hydrogène périphériques peuvent éventuellement être substitués par des groupes alkyle, alcoxy, phénoxy, dialkylamino ou diphénylamino (alkyle = en C₁ à C₆) ;
par ailleurs, R¹ et R², dans le type de composé XV, peuvent également être des groupements alkyle (en C₁-C₆) ramifiés ou non ramifiés ou former conjointement un noyau pyrrolidine, pipéridine ou morpholine avec l'atome d'azote lié ;
R³ et R⁴ peuvent, en outre, être également, indépendamment l'un de l'autre, un H ;
R⁸ peut être une liaison chimique ou un système (Hét)arylène bifonctionnel et correspondant, c'est-à-dire un système de noyau carbocyclique ou hétérocyclique conjugué, qui peut être constitué de types de noyau identiques ou différents, condensés ou liés de façon linéaire ou angulaire, où les atomes d'hydrogène périphériques peuvent éventuellement être substitués par des groupes alkyle, alcoxy, phénoxy, dialkylamino ou diphénylamino (alkyle = en C₁ à C₆).

2. Procédé de préparation des luminophores 1,3,2-dioxaborine XI, XII et XIII par réaction de dérivés 1,3-dicéto dans de l'anhydride acétique avec un dérivé de l'acide borique.

3. Procédé selon la revendication 2, dans lequel, par une réaction d'échange de ligands, deux ligands acétate sur un luminophore 1,3,2-dioxaborine sont remplacés par un ligand bidenté, tel qu'un acide dicarboxylique.

4. Procédé selon l'une quelconque des revendications 2 ou 3, dans lequel un composé acétylique est transformé en la 4-méthyl-6-(hét)aryl-2,2-difluoro-1,3,2-dioxaborine à méthylène actif XIV/XVI par la réaction d'acylation avec du trifluorure de bore dans de l'anhydride acétique, et dans une étape de réaction subséquente, les luminophores 1,3,2-dioxaborine vinylogues XV sont obtenus à partir du composé à méthylène actif avec un arylaldéhyde quelconque.

5. Procédé selon la revendication 4, dans lequel le composé acétylique est une aminothièn-5-ylacétophénone 2-N,N-disubstituée VII et/ou l'arylaldéhyde est un amino-5-formylthiophène 2-N,N-disubstitué IX.

6. Utilisation d'un luminophore 1,3,2-dioxaborine du type XI, XII, XIII, XIV et/ou XV dans une diode électroluminescente organique.

7. Utilisation d'un luminophore 1,3,2-dioxaborine du type XI, XII, XIII, XIV et/ou XV dans un composant électronique avec une couche fonctionnelle organique, tel qu'une cellule solaire, dans un transistor à effet de champ et/ou un composant photoréfractif.
